**Europäisches Patentamt**

**European Patent Office**

**Office européen des brevets**

(19)

(11) Veröffentlichungsnummer: **0 249 805**
**A2**

# EUROPÄISCHE PATENTANMELDUNG

(12)

(21) Anmeldenummer: **87108006.5**

(22) Anmeldetag: **03.06.87**

(51) Int. Cl.⁴: **E 04 B 1/92**

(30) Priorität: **14.06.86 DE 3620172**

(43) Veröffentlichungstag der Anmeldung: **23.12.87**
**Patentblatt 87/52**

(84) Benannte Vertragsstaaten: **CH DE FR GB IT LI**

(71) Anmelder: **VACUUMSCHMELZE GMBH, Grüner Weg 37 Postfach 2253, D-6450 Hanau 1 (DE)**

(72) Erfinder: **Naunheim, Hans-Dieter, Obermarkstrasse 45, D-5401 Kobern-Gondorf (DE)**
Erfinder: **Bork, Jochen, Dr., Willstätterstrasse 6, D-6450 Hanau 1 (DE)**

(54) **Abschirmhülle aus elektrisch leitenden Elementen.**

(57)  Eine Abschirmhülle zur Abschirmung eines Raumes gegen niederfrequente Wechselfelder besteht aus miteinander verschraubten Platten (1 und 2). Erfindungsgemäß werden Platten relativ großen Querschnittes aus Aluminium verwendet, die mindestens teilweise mit Kupfer (4) plattiert sind. Zwischen benachbarten, mit Abstand verlegten Platten sind miteinander durch Schrauben (7) verbundene Leisten (5 und 6) vorgesehen. Mindestens eine der Leisten (5) ist aus Kupfer oder einer Kupferlegierung und liegt an den mit Kupfer plattierten Oberflächen der benachbarten Platten an. Hierdurch erhält man eine leicht montier- und demontierbare Abschirmhülle, deren Schirmfaktor demjenigen einer geschweißten Konstruktion weitgehend entspricht.

Vacuumschmelze GmbH                    VP 86 P 9559
Hanau

## Abschirmhülle aus elektrisch leitenden Elementen
------------------------------------------------

Die Erfindung betrifft eine Abschirmhülle aus miteinander verschraubten, elektrisch leitenden Elementen.

Zur Abschirmung von Räumen gegen magnetische Wechselfelder ist es bekannt, diese Räume mit Wandelementen aus einem elektrisch leitenden Material auszukleiden.

Eine Abschirmung von Meßräumen gegen hochfrequente Wechselfelder ist beispielweise beschrieben in den SIEMENS-Bauteileinformationen 8 (1970) Sonderheft Funk-Entstörung, Seiten 26 bis 31. Hieraus sind Abschirmkabinen bekannt, deren seriengefertigte Normalteile miteinander verschraubt werden.

Will man derartige Kabinen auch gegen niederfrequente Wechselfelder abschirmen, so muß man allein oder zusätzlich zur magnetischen Abschirmhülle eine elektrisch leitende Abschirmhülle aus Platten mit relativ großem Querschnitt wählen. Derartige Abschirmhüllen stellt man vorzugsweise aus Aluminium her, da dieses Material bezogen auf das Gewicht eine gute Leitfähigkeit besitzt.

11.Juni 1986
G-VP-C/Bz

0249805

- 2 -

Schwierigkeiten bereitet aber die Herstellung größerer
Abschirmkammern aus Aluminium, vor allem wegen der sich
bildenden Oberflächenoxidschicht, die beim Verschweißen
Schwierigkeiten verursacht und die beim Verschrauben
von leitenden Platten einen hohen Übergangswiderstand
verursacht.

Aufgabe der vorliegenden Erfindung ist es, zur
Abschirmung niederfrequenter Felder eine Abschirmhülle
anzugeben, deren Elemente miteinander verschraubt werden
können, ohne daß gegenüber einer Abschirmhülle aus miteinander verschweißten Elementen eine Verringerung der
Abschirmwirkung auftritt.

Diese Aufgabe wird erfindungsgemäß dadurch gelöst, daß
zur Abschirmung gegen niederfrequente, magnetische
Felder im Frequenzbereich unterhalb 1000 bis zu 1 Hz
für die Elemente einer Abschirmkammer Platten aus
Aluminium vorgesehen sind, daß die Platten mindestens
teilweise mit Kupfer plattiert sind und daß der
Zwischenraum zwischen benachbarten Platten von zwei
durch Schrauben zusammengehaltenen Leisten überbrückt
ist, von denen mindestens eine mit einer Oberfläche

- 3 -

aus Kupfer oder einer Kupferlegierung auf der mit einer Kupferplattierung versehenen Oberfläche jeder der beiden von der Leiste überbrückten Platten aufliegt.

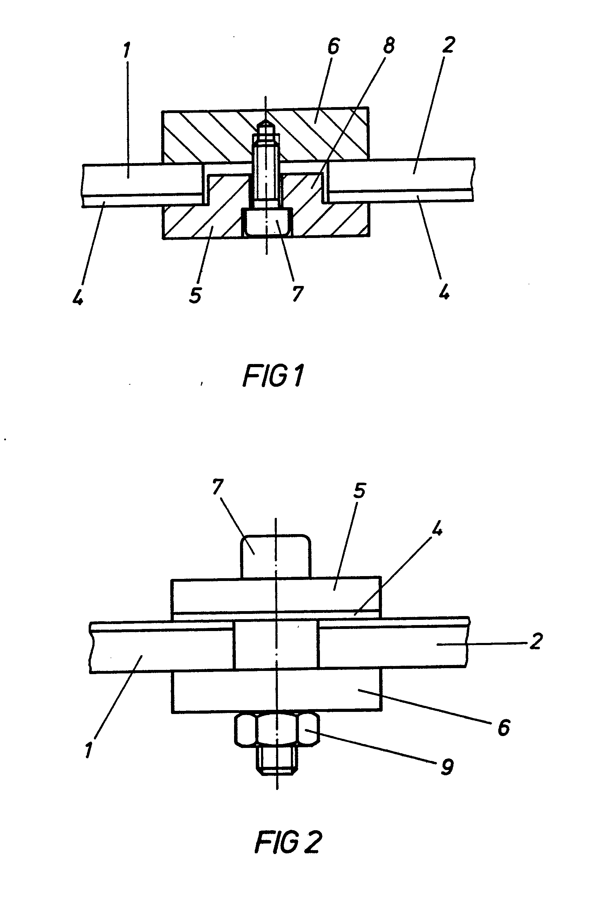

In den Figuren 1 und 2 sind Ausführungsbeispiele der Erfindung schematisch dargestellt. Benachbarte Platten 1 und 2 bestehen im wesentlichen aus Aluminium 3 und sind an einer der beiden Plattenoberflächen mit Kupfer 4 plattiert. Die Platten 1 und 2 werden so verlegt, daß sie voneinander einen Abstand besitzen. Dieser Abstand wird von zwei Leisten 5 und 6 überbrückt. Dabei besteht die Leiste 5 aus Kupfer oder aus Kupferberyllium und liegt an der aufplattierten Schicht aus Kupfer 4 sowohl an der Platte 1 als auch an der Platte 2 an. Die Leiste 6 besteht im Ausführungsbeispiel nach Figur 1 aus Aluminium und liegt an der Aluminiumoberfläche der Platten 1 und 2 an. Beide Leisten werden durch Schrauben 7 zusammengehalten, die den nötigen Anpreßdruck der Leisten 5 und 6 an die Oberfläche der Platten 1 und 2 erzeugen. Die Leiste 5 besitzt einen Vorsprung 8, der in den Raum zwischen den Platten 1 und 2 hineinragt und so deren Abstand fixiert.

- 4 -

Im Ausführungsbeispiel nach Fiugur 2 werden die Leisten 5 und 6 durch Schrauben 7 mit Muttern 9 zusammengehalten. Wiederum besteht die Leiste 6 aus Aluminium, während die Leiste 5 aus Aluminium mit einer Kupferplattierung besteht, also den gleichen Aufbau hat, wie die Platten 1 und 2. Wiederum liegen jeweils Kupfer- und Aluminiumoberflächen aneinander. Hierdurch wird eine besonders gute Leitfähigkeit erzielt, da der Übergangswiderstand bei den aufeinanderliegenden Schichten aus Kupfer im Vergleich zu Aluminium sehr gering ist.

In der nachstehenden Tabelle 1 sind die Schirmfaktoren bei verschiedenen Frequenzen dargestellt. Zum Vergleich dient eine Schraubverbindung zwischen Aluminiumplatten, eine Schraubverbindung nach der Erfindung und eine Abschirmhülle mit verschweißten Aluminiumplatten.

T a b e l l e   1

------------------

| Frequenz | Schirmfaktoren | | |
|---|---|---|---|
| | S1/* | S2/** | S3/*** |

| | | | |
|---|---|---|---|
| 2 | 1,2 | 1,2 | 1,3 |
| 5 | 1,6 | 2,0 | 2,0 |
| 10 | 2,7 | 3,5 | 3,8 |
| 20 | 5,0 | 7,0 | 7,3 |
| 50 | 13,0 | 18,0 | 18,5 |
| 100 | 25,7 | 36,0 | 38,0 |
| 200 | 53,7 | 78,0 | 80,0 |
| 500 | 165,6 | 281,0 | 256,0 |
| 1000 | 533,0 | 1678,0 | 885,0 |

* Aluminium - Aluminium - Preßschraubverbindung

| | | |
|---|---|---|
| Anzugsmoment | : | 60 Nm |
| Schraubenabstand | : | 60 mm |
| Schraube | : | A4/M8 |

** Preßschraubverbindung mit kupferplattiertem Aluminium, Cu-Seiten aufeinanderliegend

| | | |
|---|---|---|
| Anzugsmoment | : | 25 Nm |
| Schraubenabstand | : | 60 mm |
| Schraube | : | A4/M8 |

*** Schweißverbindung Aluminium - Aluminium

Vacuumschmelze GmbH       VP 86 P 9559 DE

  Hanau


P a t e n t a n s p r ü c h e

1. Abschirmhülle aus miteinander verschraubten, elektrisch leitenden Elementen,
d a d u r c h   g e k e n n z e i c h n e t ,
daß zur Abschirmung gegen niederfrequente, magnetische Felder im Frequenzbereich unterhalb 1000 bis zu 1 Hz für die Elemente einer Abschirmkammer Platten (1, 2) aus Aluminium vorgesehen sind,
daß die Platten mindestens teilweise mit Kupfer (4) plattiert sind und
daß der Zwischenraum zwischen benachbarten Platten von zwei durch Schrauben (7) zusammengehaltenen Leisten (5, 6) überbrückt ist, von denen mindestens eine mit einer Oberfläche aus Kupfer (4) oder einer Kupferlegierung auf der mit Kupfer (4) plattierten Oberfläche jeder der beiden von der Leiste (5) überbrückten Platten (1, 2) aufliegt.

2. Abschirmhülle aus miteinander verschraubten, elektrisch leitenden Elementen nach Anspruch 1,
d a d u r c h   g e k e n n z e i c h n e t ,
daß eine der den Zwischenraum zwischen zwei Platten (1, 2) überbrückende Leiste (5) aus mit Kupfer (4) plattiertem Aluminium besteht.


11. Juni 1986
G-VP-C/Bz.

3. Abschirmhülle aus miteinander verschraubten, elektrisch leitenden Elementen, nach Anspruch 1,
d a d u r c h  g e k e n n z e i c h n e t ,
daß eine Oberfläche jeder Platte (1, 2) vollständig mit Kupfer (4) plattiert ist.

4. Abschirmhülle aus miteinander verschraubten, elektrisch leitenden Elementen, nach Anspruch 1,
d a d u r c h  g e k e n n z e i c h n e t ,
daß eine der miteinander verschraubten Leisten (5, 6) aus Kupfer (4) und die anderen aus Aluminium besteht und
daß sie an Oberflächen der Platten (1, 2) aus jeweils gleichem Material anliegen.

11. Juni 1986
G-VP-C/Bz.

0249805

VP86 P 9559

FIG 1

FIG 2